# EUROPÄISCHE PATENTSCHRIFT

(11) **EP 0 709 957 B1**
(45) Veröffentlichungstag und Bekanntmachung des Hinweises auf die Patenterteilung: **18.09.2002**
(21) Anmeldenummer: 95250259.9
(22) Anmeldetag: 26.10.1995
(51) Int. Cl.: H03H 9/64

(54) **Akustisches Oberflächenwellenbauelement und Verfahren zur Herstellung**
Surface acoustic wave component and process for producing the same
Composant à ondes acoustiques de surface et son procédé de fabrication

(30) Priorität: 26.10.1994 DE 4439489
(43) Veröffentlichungstag der Anmeldung: 01.05.1996
(73) Patentinhaber: TELE FILTER tft GmbH, 14513 Teltow (DE)
(72) Erfinder: Wall, Bert, Dr., D-14471 Potsdam (DE); du Hamél, André, D-12051 Berlin (DE)
(74) Vertreter: Hengelhaupt, Jürgen, Dipl.-Ing.

(56) Entgegenhaltungen:
- GB-A- 2 117 992
- PROC OF THE 38th ANNUAL FREQUENCY CONTROL SYMP; 29 MAY- 1 JUNE 1984; PHILADELPHIA; M. TANAKA et al: NARROW BANDPASS FILTER USING DOUBLE-MODE SAW RESONATORS ON QUARTZ
- G. Martin et al., "Four Modes Waveguide Resonator Filters", 1993-01-17, Ultrasonics Symp. Proc., S. 35-39

## Beschreibung

Die Erfindung betrifft akustische Oberflächenwellenbauelemente, wie Bandpaßfilter und Oszillatoren, insbesondere schmalbandige Filter und ist anwendbar in der Elektrotechnik und Elektronik, und ein Verfahren zur Herstellung.
Ein bevorzugtes Anwendungsgebiet der Erfindung ist die Funktechnik, insbesondere die Mobilfunktelekommunikationstechnik.

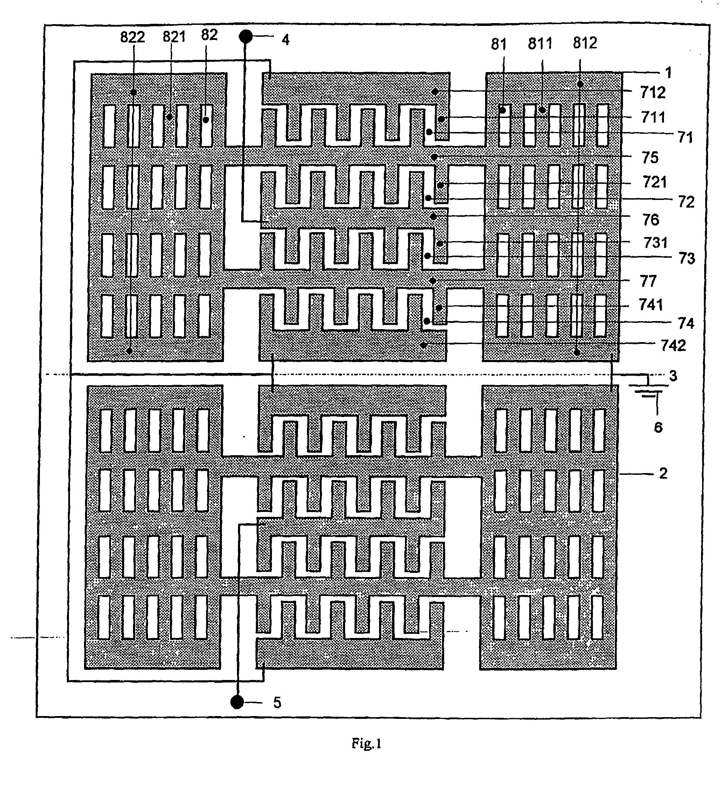

Es sind akustische Oberflächenwellenbauelemente bekannt, bei denen zwei akustische Oberflächenwellenresonatoranordnungen über elektrisch leitende Verbindungen (M. Tanaka, T. Morita, K. Ono, Y. Nakazawa, "Narrow Bandpass Filters Using Double-Mode SAW Resonators on Quartz", 1984 IEEE Frequency Control Proc., S. 286) oder über einen Zweipol (DE 42 27 362 A1)zu einer Resonatorkaskade verschaltet sind, wobei entweder jede der akustischen Oberflächenwellenresonatoranordnungen aus zwei auf einem piezoelektrischen Substrat liegenden interdigitalen Wandlern mit beiderseits dieser Wandler angeordneten Streifenreflektoren aufgebaut ist und diese Wandler symmetrisch bzw. antisymmetrisch zu einer zu beiden Wandlern gehörenden gemeinsamen Sammelelektrode sind, die sich bis weit in beide Streifenreflektoren erstreckt, oder jede dieser akustischen Oberflächenwellenresonatoranordnungen aus vier parallel zueinander auf einem piezoelektrischen Substrat liegenden interdigitalen Wandlern und beiderseits dieser Wandler angeordneten Streifenreflektoren aufgebaut ist, deren innere interdigitale Wandler symmetrisch bzw. antisymmetrisch zu einer zu beiden Wandlern gehörenden gemeinsamen Sammelelektrode sind, die sich mit Unterbrechungen zwischen interdigitalem Wandler und dem linken und rechten Streifenreflektor bis an die äußeren Begrenzungen beider Streifenreflektoren erstreckt, und deren äußere interdigitale Wandler symmetrisch bzw. antisymmetrisch zu der gemeinsamen Sammelelektrode der inneren Wandler sind und die inneren Sammelelektroden der äußeren Wandler mit den äußeren Sammelelektroden der inneren Wandler gemeinsame Elektroden bilden, und diese gemeinsame Elektroden sich mit möglichen Unterbrechungen zwischen den interdigitalen Wandlern und dem linken und rechten Streifenreflektor bis an die äußeren Begrenzungen beider Streifenreflektoren, jedoch mindestens über die Länge der interdigitalen Wandler erstrecken (G. Martin, B. Wall, R. Kunze, M. Weihnacht, "Four Modes Waveguide Resonator Filters", 1993 Ultrasonics Symp. Proc., S. 35-39; weitere Erläuterungen zu diesem Stand der Technik sind in der Beschreibung zu Fig.1 enthalten).

Die bekannten Oberflächenwellenresonatoranordnungen sind Wellenleiter für akustische Oberflächenwellen, weil die Phasengeschwindigkeit im Gebiet der Reflektorstreifen und Wandlerfinger kleiner ist als in den sich daran anschließenden äußeren Gebieten, die homogen metallisiert sind. Diese Oberflächenwellenresonatoranordnungen werden daher auch als transversal gekoppelte Wellenleiterresonatorfilter bezeichnet. Bei der Verwendung von Oberflächenwellenresonatoranordnungen mit zwei interdigitalen Wandlern dienen die äußeren Sammelelektroden der Wandler als Eingang, Ausgang oder Koppelelektrode. Die innere gemeinsame Elektrode liegt auf Massepotential. Bei der Verwendung von Oberflächenwellenresonatoranordnungen mit 4 interdigitalen Wandlern dient die gemeinsame Sammelelektrode der inneren Wandler als Ein- bzw. Ausgangselektrode und die äußeren Sammelelektroden der äußeren Wandler als Koppelelektroden. Die gemeinsamen Sammelelektroden der inneren und äußeren Wandler liegen auf Massepotential. Mit Hilfe von Anpaßschaltungen an Ein- und Ausgang des Bauelements wird die Welligkeit im Durchlaßbereich geglättet.

Diese bekannten Lösungen haben den Nachteil, daß die Oberflächenwellenbauelemente nicht symmetrisch, d. h. mit zwei Signalen gleicher Amplitude und einem Phasenunterschied von 180°, betrieben werden können.

Weiterhin ist aus der GB 21 17 992 A eine akustische Oberflächenwellenresonatoranordnung bekannt, welche parallel-seriell verschaltete mit akustischen Wellen arbeitende Bauelemente beschreibt. Bezug genommen wird sowohl auf mit Volumenwellen arbeitende als auch mit akustischen Oberflächenwellen arbeitende Bauelemente. Es wird eine Lösung beschrieben, die es ermöglicht, die Leistungsbelastbarkeit der Bauelemente zu erhöhen. Dabei wird davon ausgegangen, daß sich die Leistungsdichte im Bauelement verringert und damit die Leistungsverträglichkeit erhöht, wenn die Apertur des Bauelementes vergrößert wird. Eine Erhöhung der Apertur führt jedoch zu einer Veränderung der elektrischen Abschlußimpedanzen. Es wird dargestellt, daß es durch elektrische Verschaltung mehrerer Oberflächenwellenbauelemente möglich ist, trotz verringerter Leistungsdichte die Abschlußimpedanzen unverändert zu lassen. So bietet z.B. die Reihenschaltung zweier Bauelemente und die anschließende Reihenschaltung zweier Parallelschaltungen unveränderte Abschlußimpedanzen. Dies wird anhand von Eintorresonatoren und longitudinal gekoppelten Zweitorresonatoren näher beschrieben. Es wird darauf hingewiesen, daß die Erfindung auch auf andere Bauelemente wie nicht resonante Strukturen und hier speziell Transversalfilter anwendbar ist.

Eintorresonatoren, longitudinal gekoppelte Zweitorresonatoren und Transversalfilter sind prinzipiell sowohl symmetrisch als auch unsymmetrisch zu betreiben. Lösungen für speziell symmetrisch zu betreibende transversal gekoppelte Wellenleiter-Resonatorfilter sind dieser Veröffentlichung nicht zu entnehmen.

Der Erfindung liegt daher die Aufgabe zugrunde, transversal gekoppelte Wellenleiterresonatorfilter mit einfachen Mitteln preiswert und zuverlässig so auszubilden, daß sie mit symmetrischer Anschaltung betrieben werden können, und ein Verfahren zur Herstellung anzugeben

Diese Aufgabe wird erfindungsgemäß gelöst durch die Merkmale im kennzeichnenden Teil der Ansprüche 1, 2, 3, 5, und 6 in Verbindung mit den Merkmalen im jeweiligen Oberbegriff.
Zweckmäßige Ausgestaltungen der Erfindung sind in Unteransprüchen enthalten.

In der Praxis führt die Notwendigkeit der Minimierung und Optimierung des Aufbaus elektronischer Schaltungen, in denen Oberflächenbauelemente eingesetzt werden, oftmals zu der Bedingung, daß diese Bauelemente nur mit einem symmetrischen Signal betrieben werden können. Das heißt, es muß abgesichert werden, daß die notwendigen physikalischen Prozesse trotz dieser besonderen Signalzu- bzw. abführung ablaufen können und ihre Funktion abgesichert ist.

Das ist im besonderen Falle transversal gekoppelter Wellenleiter-Resonatorfilter, die derzeit in großer Anzahl in Systemen der Mobilfunktechnik eingesetzt werden, mit den derzeit bekannten Ausführungsformen nicht möglich. Die Erfindung schafft somit den Vorteil, diese wichtigen Bauelemente ohne zusätzliche Symmetrierglieder auch in elektronischen Schaltungen einsetzen zu können, die auf der Basis symmetrischer Signale arbeiten, indem eine Symmetrierung der Eingangs- und/oder Ausgangssignale durch eine räumliche Phasendrehung und/oder Teilung der Sammelelektroden der interdigitalen Wandler und/oder Verschaltung mehrerer transversal gekoppelter Oberflächenwellenresonatoranordnungen auf einem piezoelektrischen Substrat erfolgt.

Dies wird erreicht dadurch, daß bei zwei auf einem piezoelektrischen Substrat liegenden interdigitalen Wandlern mit Streifenreflektoren und Sammelelektrode die gemeinsame Sammelelektrode so geteilt ist, daß annähernd gleich viele Wandlerfinger beider Wandler an die zwei durch die Teilung entstehenden Sammelelektroden angeschlossen sind, wobei die in den interdigitalen Wandlern verwendete Anschlußordnung, d. h. ein alternierender Anschluß der Finger an die beiden Sammelelektroden eines interdigitalen Wandlers, an der Trennstelle der gemeinsamen Sammelelektrode umgekehrt wird, und daß je eine Phase des symmetrischen Eingangsoder Ausgangssignales an die beiden durch die Teilung der gemeinsamen Sammelelektrode entstehenden Elektroden angeschlossen ist.

Bei vier auf einem piezoelektrischen Substrat liegenden interdigitalen Wandlern mit Streifenreflektoren und mehreren Sammelelektroden wird der Vorteil dadurch realisiert, daß gemeinsame Sammelelektroden geteilt sind derart, daß die gemeinsame Sammelelektrode der mittleren interdigitalen Wandler oder die äußeren Sammelelektroden der äußeren interdigitalen Wandler so geteilt sind, daß annähernd gleich viele Wandlerfinger der anliegenden Wandler an die durch die Teilung entstehenden Sammelelektroden angeschlossen sind, wobei die in den interdigitalen Wandlern verwendete Anschlußordnung, d. h. ein alternierender Anschluß der Finger an die beiden Sammelelektroden eines interdigitalen Wandlers, an der Trennstelle der Sammelelektroden umgekehrt wird.

Die Anzahl der Wandlerfinger, die an die durch die Teilung der Sammelelektroden entstandenen Elektroden angeschlossen ist, kann gleich der Hälfte der an eine nicht geteilte Elektrode angeschlossenen Finger sein.

Dabei ist es notwendig, verschiedene Möglichkeiten der Umsetzung des symmetrischen Signals in diesen Bauelemente zu finden, da in Abhängigkeit von der verwendeten Schaltungsumgebung unterschiedliche Impedanzen am Eingang bzw. Ausgang der Bauelemente abzusichern sind. Mit den verschiedenen nebengeordneten Lösungen werden unterschiedliche Impedanzbereiche abgedeckt, indem entweder die gemeinsame Sammelelektrode so geteilt wird, daß zwei galvanisch voneinander getrennte Elektroden entstehen, die sich mindestens über die gesamte Länge der Wandler erstrecken oder die beiden Phasen des symmetrischen Eingangs- oder Ausgangssignales an je eine äußere Sammelelektrode der äußeren interdigitalen Wandler angeschlossen ist und daß die Anschlußordnung der Finger eines der äußeren interdigitalen Wandler vertauscht ist, d. h. die Finger an die jeweils gegenüberliegende Sammelelektrode dieser Wandler angeschlossen sind.
Ebenso ist es möglich, daß zwei der verschalteten Oberflächenwellenresonatoranordnungen auf einem piezoelektrischen Substrat liegen, bei denen je eine Phase des symmetrischen Eingangs- und Ausgangssignales an je eine dieser zwei verschalteten Oberflächenwellenresonatoranordnungen angeschlossen sind.
Die Erfindung soll nachstehend anhand von teilweise in den Figuren dargestellten Ausführungsbeispielen näher erläutert werden. Es zeigen:
- Fig.1: Eine Kaskadierung von Oberflächenwellenresonatoren gemäß dem bekannten Stand der Technik
- Fig.2: Eine Oberflächenwellenresonatoranordnung mit getrennten gemeinsamen Sammelelektroden der Wandler
- Fig. 3: Eine Oberflächenwellenresonatoranordnung mit zwei spiegelsymetrisch angeordneten Oberflächenwellenresonatorstrukturen
- Fig.4: Eine Oberflächenwellenresonatoranordnung, bestehend aus vier Oberflächenwellenresonatorstrukturen
- Fig.5: Eine Oberflächenwellenresonatoranordnung mit zwei spiegelsymetrisch angeordneten Oberflächenwellenresonatorstrukturen und galvanisch getrennter innerer Sammelelektrode
- Fig.6: Eine Oberflächenwellenresonatoranordnung, bestehend aus vier unabhängigen, identischen Oberflächenwellenresonatorstrukturen

In Fig.1 ist die bekannte Kaskadierung von Oberflächenwellenresonatoranordnung mit vier interdigitalen Wandlern dargestellt (s. a. G. Martin, B. Wall, R. Kunze, M. Weihnacht, "Four Modes Waveguide Resonator Filters", 1993 Ultrasonics Symp. Proc., S. 35-39 ). Diese Anordnung besteht aus zwei gleichen, spiegelsymmetrisch zur Mittellinie 3 liegenden Oberflächenwellenresonatoranordnungen 1 und 2, die lediglich kaskadiert sind. Deshalb ist es ausreichend, nur die Oberflächenwellenresonatorstruktur näher zu erläutern, die oberhalb der Mittellinie 3 liegt. Diese Anordnung besteht aus vier interdigitalen Wandlern 71,72,73,74, deren Wandlerfinger 711,721,731,741 mit Sammelelektroden 712,742, die teilweise von zwei Wandlern gemeinsam genutzt werden 75,76,77, sowie Streifenreflektoren 81,82, mit Metallstreifen 811,821, die sowohl über Elektroden 812, 822 als auch über die bis zu den äußeren Begrenzungen der Streifenreflektoren verlängerten gemeinsamen Sammelelektroden 75,76,77 elektrisch kurzgeschlossen sind. Die Wandlerfinger 711,721,731,741 und die Reflektorstreifen 811,821 sind zueinander parallel angeordnet.

Die gemeinsamen Sammelelektroden der äußeren Wandler 75 und 77 sind über die elektrisch kurzgeschlossenen Streifenreflektoren mit der Masse 6 verbunden, die äußeren Sammelelektroden 712 und 742 sind elektrisch miteinander verbunden und dienen als Ausgang der Oberflächenwellenresonatoranordnung.
Die Signalzuführung erfolgt über den Anschluß 4, der elektrisch leitend mit der inneren Sammelelektrode 76 verbunden ist. Die akustische Oberflächenwelle (AOW) wird in jedem der Wandler 71,72,73,74 durch die unterschiedlichen Potentiale an benachbarten Wandlerfingern angeregt und breitet sich in der Wandlerstruktur parallel zu den Sammelelektroden aus.
Die Funktion der Struktur basiert darauf, daß die Geschwindigkeit der AOW im Streifen -bzw. Fingergebiet kleiner ist als in den metallisierten Bereichen, die durch die Sammelelektroden 712,742 und 812,822 gebildet werden. Deshalb wirkt die Struktur transversal betrachtet als Wellenleiter für die AOW. In Wellenleitern können sich verschiedene symmetrische und antisymmetrische Moden ausbilden, die durch verschiedene Geschwindigkeiten und Energieverteilungen transversal zur Wellenausbreitungsrichtung gekennzeichnet sind. In der betrachteten Struktur werden die ersten beiden antisymmetrischen Moden wie folgt angeregt:
Da die zweite antisymmetrische Mode außer einem Nulldurchgang in der Mitte der Gitterstruktur (d.h. entlang der Elektrode 76) zwei weitere Nulldurchgänge in gleichem Abstand transversal zur Mitte aufweist, wird eine Anregung und Detektierung der ersten beiden antisymmetrischen Moden dadurch erreicht, daß je ein Wandler ein Viertel der Gesamtbreite der Struktur ausfüllt. Weiterhin wird eine notwendige antisymmetrische Feldverteilung verwirklicht, indem in der betrachteten Struktur die von den parallel geschalteten Wandler in der oberen und unteren Strukturhälfte erzeugten Felder entgegengesetzte Richtung haben. Folglich wird durch die Ordnung der Alternanz des Anschlusses der Wandlerfinger 711,721,731,741 an die Sammelelektroden 712,75,76,77,742 bestimmt, welche Modenkombination ausgebildet wird.
Der hauptsächlich durch die Breite des Wellenleiters bestimmte Modenabstand bestimmt die Bandbreite des angepaßten Filters.
Die Kaskadierung der Strukturen 1 und 2 dient lediglich der Erhöhung der Flankensteilheit und Selektionseigenschaften der Filterstruktur.

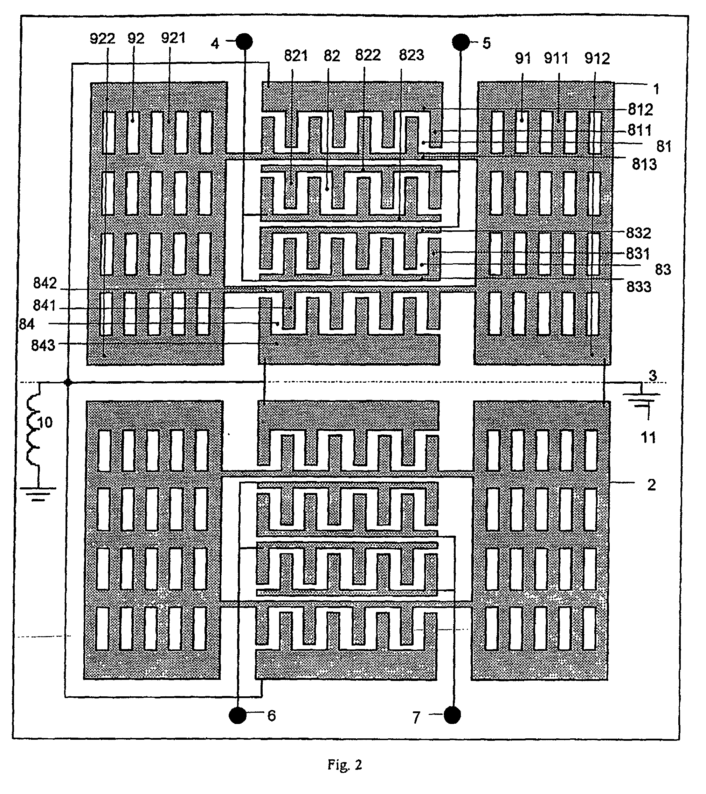

Ein erstes Lösungsbeispiel der vorliegenden Erfindung besteht gemäß Fig.2 darin, die gemeinsamen Anschlußelektroden der Wandler (75,76,77 im Bild 1) so zu trennen, daß die Wandler keine gemeinsame Sammelelektroden mehr besitzen, und die Möglichkeit der Anregung einer AOW zwischen den durch unterschiedliche Signalphasen gespeisten Wandlerfingern auszunutzen.
Dieses Lösungsbeispiel besteht aus zwei Oberflächenwellenresonatorstrukturen 1 und 2. Sie ist zur Mittellinie 3 spiegelsymmetrisch aufgebaut, deshalb ist es ausreichend, nur den Teil 1 der Anordnung näher zu erläutern, der oberhalb der Mittellinie 3 liegt. Dieser Teil besteht aus interdigitalen Wandlern 81,82,83,84 deren Wandlerfinger 811,821,831,841 alternierend an die jeweiligen Sammelelektroden 812 und 813, 822 und 823, 832 und 833, 842 und 843 angeschlossen sind, sowie Streifenreflektoren 91,92, mit Metallstreifen 911,921, die sowohl über Elektroden 912,922, als auch über die bis zu den äußeren Begrenzungen der Streifenelektroden verlängerten ungeteilten Sammelelektroden elektrisch kurzgeschlossen sind. Die Wandlerfinger 811,821,831,841 und die Reflektorstreifen 911,921 sind zueinander parallel angeordnet.
Im Gegensatz zu der bekannten Oberflächenwellenresonatoranordnung gemäß Fig.1 sind jedoch bei der Erfindung die gemeinsamen Sammelelektroden der inneren Wandler sowie die der äußeren Wandler in zwei galvanisch voneinander getrennte Elektroden 813 und 822, 823 und 832, 833 und 842 geteilt, wobei die Summe aus den Breiten der jeweiligen Teilelektroden und dem Abstand zwischen ihnen die ursprüngliche Breite der gemeinsamen Sammelelektrode nicht übersteigt. Damit bleibt die Wirkung der beiden elektrisch getrennten Teilelektroden auf die Modengeschwindigkeiten annähernd die gleiche, wie die einer ungeteilten Sammelelektrode.
Die inneren Sammelelektroden der beiden äußeren Wandler 813 und 842 sind über die elektrisch kurzgeschlossenen Streifenreflektoren mit der Masse 11 verbunden, die äußeren Sammelelektroden 812 und 843 sind elektrisch miteinander verbunden.
Die Signalzuführung erfolgt dergestalt, daß die beiden Phasen 5 und 6 des elektrischen Signals so an die Sammelelektroden der beiden inneren Wandler 82 und 83 gegeben werden, daß die beiden Sammelelektroden 822 und 823 bzw. 832 und 833 eines jeden der beiden Wandler jeweils von unterschiedlichen Phasen gespeist werden. Zwischen den beiden unterschiedlichen Potentialen, die durch die beiden Signalphasen an benachbarten Wandlerfingern der Wandler 82 und 83 erzeugt werden, wird eine AOW angeregt. Es hat sich als günstig erwiesen, zur Minimierung des Übersprechpegels die im Bild dargestellte Anordnung zu wählen, bei der unterschiedliche Phasen 5 und 6 an die äußeren Sammelelektroden 822 und 833 der inneren Wandler 82 und 83 geführt werden, die zu den inneren (an Masse 11 angeschlossenen) Elektroden 813 und 842 der äußeren Wandler 81 und 84 parallel liegen.
Diese Anschlußform erfordert eine räumliche Phasendrehung in einem der beiden inneren Wandler 82 bzw. 83 durch eine Umkehrung bei der Alternanz der Anschlüsse der Finger an die Sammelelektroden gegenüber der Anordnung in der bekannten Struktur (Bild 1, Wandler 72,73). Im Lösungsbeispiel wird die Phasendrehung durch eine umgekehrte Anschlußordnung der Finger 831 an die Sammelelektroden 832 und 833 des Wandlers 83 realisiert.
Diese Anschlußordnung sichert bei der dargestellten Art der Signalzuführung eine antisymmetrische Feldverteilung ab, da die Felder der parallel geschalteten Wandler in der oberen und unteren Strukturhälfte entgegengesetzte Richtung haben. Deshalb erfolgt eine Anregung der ersten beiden antisymmetrischen Moden. Das Ausgangssignal wird zwischen den äußeren Sammelelektroden 812 und 843 abgenommen und als Eingangssignal auf die äußeren Sammelelektroden der zweiten Oberflächenwellenresonatorstruktur 2 gegeben, zu der parallel eine Spule 10 geschaltet ist, die die elektrische Kopplung zwischen den beiden Oberflächenwellenresonatoranordnungen verstärkt.

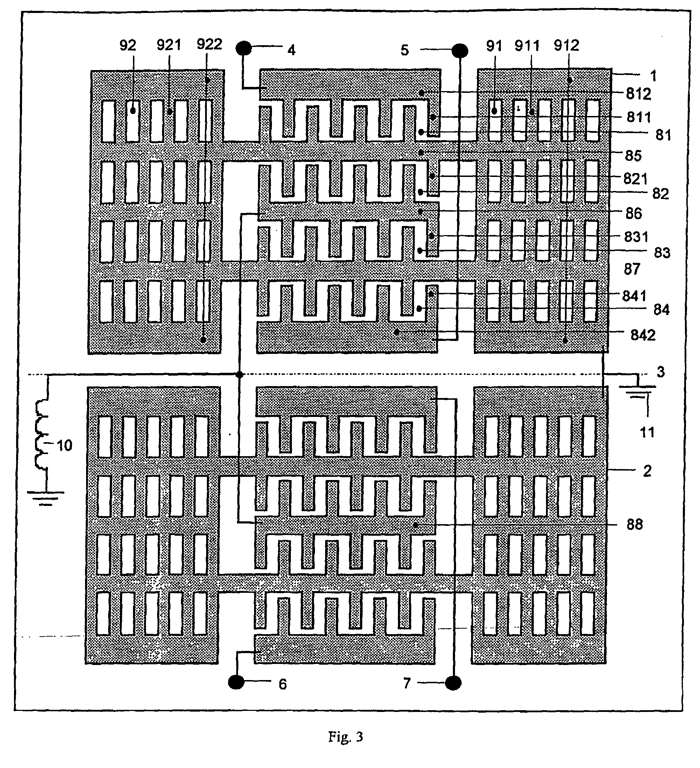

Ein zweites Lösungsbeispiel der vorliegenden Erfindung ist in Fig.3 dargestellt.

Die Anordnung besteht aus zwei Oberflächenwellenresonatorstrukturen 1 und 2, die zur Mittellinie 3 spiegelsymmetrisch liegen. Deshalb ist es ausreichend, nur den Teil 1 der Anordnung näher zu erläutern, der oberhalb der Mittellinie 3 liegt. Dieser Teil besteht aus interdigitalen Wandlern 81,82,83,84 deren Wandlerfinger 811,821,831,841 alternierend an die jeweiligen Sammelelektroden 812, 842 85,86,87, angeschlossen sind, die teilweise von zwei Wandlern gemeinsam genutzt werden sowie Streifenreflektoren 91,92 mit Metallstreifen 911,921, die sowohl über Elektroden 912, 922 als auch über die bis zu den äußeren Begrenzungen der Streifenreflektoren verlängerten gemeinsamen Sammelelektroden 85,87 elektrisch kurzgeschlossen sind. Die Wandlerfinger 811,821,831,841 und die Reflektorstreifen 911,921 sind zueinander parallel angeordnet. Die gemeinsamen äußeren Sammelelektroden 85 und 87 sind über die elektrisch kurzgeschlossenen Streifenreflektoren mit der Masse 9 verbunden.
Die beiden Phasen 4 und 5 des Eingangssignals werden auf die beiden äußeren Sammelelektroden 812 und 842 gegeben. Im Gegensatz zum ersten Lösungsbeispiel erfolgt die Anregung der AOW innerhalb der Eingangswandler 81 und 84 zwischen dem jeweiligen Signalpotential und dem Massepotential, das an den Sammelelektroden 85 und 87 anliegt.
Die dargestellte Anordnung unterscheidet sich von der bekannten Oberflächenwellenresonatoranordnung in Fig.1 dadurch, daß im Wandler 84 die Alternanz der Anschlüsse der Finger an die Sammelelektroden 841 bzw. 842 gegenüber der Anordnung im Wandler 74 (Fig.1) der bekannten Struktur umgekehrt wurde. Damit wird die Gegenphasigkeit des Eingangssignals durch eine räumliche Phasenverschiebung im Wandler 84 kompensiert und eine transversale Energieverteilung entsprechend der für die Anregung der ersten beiden antisymmetrischen Moden notwendigen realisiert. Das Ausgangssignal wird an der inneren Sammelelektrode 86 abgenommen und als Eingangssignal auf die innere Elektrode 88 der zweiten Oberflächenwellenresonatoranordnung 2 gegeben, zu der parallel eine Spule 10 geschaltet ist, die die elektrische Kopplung zwischen den beiden Oberflächenwellenresonatoranordnungen verstärkt.

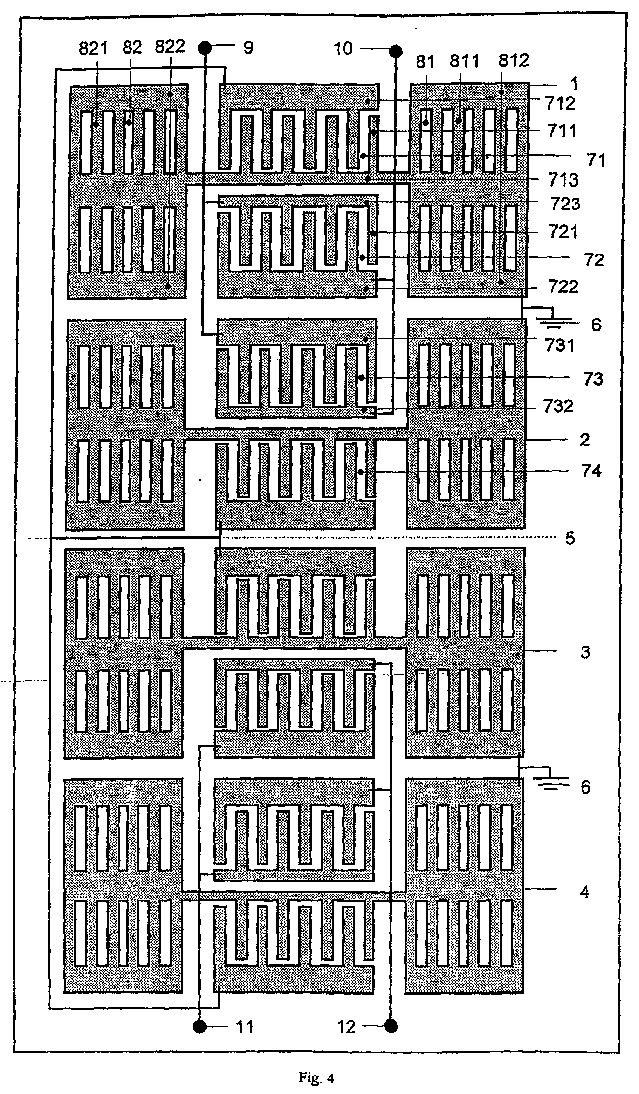

Mit dem dritten Lösungsbeispiel gemäß Fig.4 wird eine symmetrische Signalzuführung bzw. -abführung für eine bekannte Kaskadierung von zwei Oberflächenwellenresonatoranordnungen realisiert, die aus zwei interdigitalen Wandlern mit beiderseits dieser Wandler angeordneten Streifenreflektoren aufgebaut ist, wobei diese Wandler symmetrisch bzw. antisymmetrisch zu einer zu beiden Wandlern gehörenden gemeinsamen Sammelelektrode liegen. Mit dieser Struktur können Modenkombinationen wie erste symmetrische und erste antisymmetrische, oder erste und zweite symmetrsiche und erste und zweite antisymmetrische Mode verwendet werden.
Das Lösungsbeispiel besteht aus vier Oberflächenwellenresonatorstrukturen 1,2,3 und 4. Die Gesamtanordnung ist zur Mittellinie 5 spiegelsymmetrisch. Es ist deshalb ausreichend, nur den Teil der Anordnung näher zu erläutern, der oberhalb der Mittellinie 5 liegt. Dieser Teil besteht aus zwei identisch angeordneten Oberflächenwellenresonatoranordnungen. Der Teil 1 best aus zwei interdigitalen Wandlern 71,72, deren Wandlerfinger 711,721 alternierend an die jeweiligen Sammelelektroden 712, 713,723,722 angeschlossen sind, sowie Streifenreflektoren 81,82 mit Metallstreifen 811,821, die sowohl über Elektroden 812, 822 als auch über die bis zu den äußeren Begrenzungen der Streifenreflektoren verlängerten gemeinsamen Sammelelektroden 713, elektrisch kurzgeschlossen sind. Die Summe aus der Breite der beiden inneren Sammelelektroden 713 und 723 und dem Abstand zwischen ihnen entspricht annähernd der Breite der gemeinsamen Sammelelektrode der bekannten Oberflächenwellenresonatoranordnung mit zwei interdigitalen Wandler bei gleichen Filterparametern. Die Wandlerfinger 711,721 und die Reflektorstreifen 811,821 sind zueinander parallel angeordnet. Die Sammelelektrode 713 ist über die elektrisch kurzgeschlossenen Streifenreflektoren mit der Masse 6 verbunden. Somit arbeitet der Wandler 71 gegen Masse. Die unterschiedlichen Phasen des Eingangssignals 9 und 10 werden nun an die Sammelelektroden 723 und 722 gegeben, die an diesen Elektroden entstehenden unterschiedlichen Potentiale führen zu einer Anregung einer AOW zwischen den zugehörigen Fingern. Innerhalb der Struktur 1 bilden sich die erste symmetrische und die erste antisymmetrische Mode aus. Das Ausgangssignal wird über die Sammelelektrode 712 und Masse abgegriffen. Die Struktur 2 ist völlig analog aufgebaut. Das gleiche gegenphasige Signal wird auch in 2 auf die Sammelelektroden 731 und 732 des nicht gegen Masse arbeitenden Wandlers 73 gegeben, und zwar dergestalt, daß in Teil 1 und 2 jeweils unterschiedliche Phasen an den inneren Sammelelektroden 723 und 732 anliegen, die zu den über die Streifenreflektoren an Masse angeschlossenen Sammelelektroden parallel liegen. Dieser Anschluß sichert eine Minimierung des Übersprechpegels der Gesamtanordnung ab. Um mit der dargestellten Anschaltungsvariante in beiden Strukturen 1 und 2 ein gleichphasiges Ausgangssignal zu erzeugen, ist die Ordnung des Anschlusses der Finger des Eingangswandlers von Teil 2 entgegengesetzt der des Eingangswandlers von Teil 1 (Wandler 71). Die Ausgangssignale von Wandler 71 und 74 werden als gemeinsames Ausgangssignal zusammengeführt und als Eingangssignal auf die spiegelsymmetrisch zur Achse 5 liegenden Strukturteile 3 und 4 gegeben.

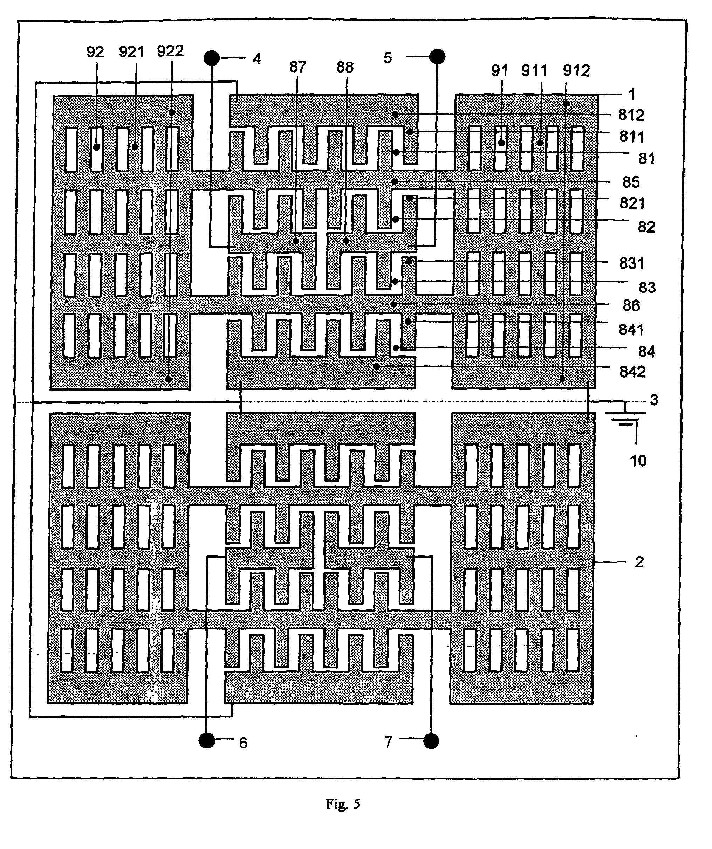

Das vierte Lösungsbeispiel ist in Fig. 5 dargestellt. Grundlage dieses Lösungsbeispiels ist die bekannte Kaskadierung von Oberflächenwellenresonatoranordnungen mit vier interdigitalen Wandlern, mit der die ersten beiden antisymmetrischen Moden angeregt werden (Fig.1). Das Lösungsbeispiel besteht aus zwei Oberflächenwellenresonatorstrukturen 1 und 2, die zur Mittellinie 3 spiegelsymmetrisch liegen. Deshalb ist es ausreichend, nur den Teil 1 der Anordnung näher zu erläutern, der oberhalb der Mittellinie 3 liegt. Dieser Teil besteht aus interdigitalen Wandlern 81,82,83,84 deren Wandlerfinger 811,821,831,841 alternierend an die jeweiligen Sammelelektroden 812, 842 angeschlossen sind, die teilweise von zwei Wandlern gemeinsam genutzt werden 85,86,87,88, sowie Streifenreflektoren 91,92 mit Metallstreifen 911,921, die sowohl über Elektroden 912, 922 als auch über die bis zu den äußeren Begrenzungen der Streifenreflektoren verlängerten gemeinsamen Sammelelektroden 85,86 elektrisch kurzgeschlossen sind. Die Wandlerfinger 811,821,831,841 und die Reflektorstreifen 911,921 sind zueinander parallel angeordnet. Die gemeinsamen Sammelelektroden der äußeren Wandler 85 und 87 sind über die elektrisch kurzgeschlossenen Streifenreflektoren mit der Masse 10 verbunden, die äußeren Sammelelektroden 812 und 842 sind elektrisch miteinander verbunden und dienen als Ausgang der Oberflächenwellenresonatoranordnung.
Im Gegensatz zu der in Fig.1 dargestellten bekannten Oberflächenwellenresonatoranordnung ist bei der erfindungsgemäßen Lösung die gemeinsame Sammelelektrode der inneren Wandler 82 und 83 längs der Wellenausbreitungsrichtung in zwei galvanisch voneinander getrennte Elektroden 87 und 88 geteilt. Je eine Phase des Eingangssignals 4 und 5 wird auf eine der beiden Elektroden 87 bzw. 88 gegeben. Um die Gegenphasigkeit der beiden Signale bei der Anregung der AOW längs der Wellenausbreitungsrichtung zu kompensieren, wurde die Anschlußordnung der Finger innerhalb eines der Wandler 82 bzw. 83 an der Trennstelle der Elektrode umgekehrt. Somit wird erreicht, daß die Fingerpolarität innerhalb der Wandler 82 und 83 den für die Anregung der AOW notwendigen Polaritätswechsel aufweist. Somit werden in der Struktur 1 die ersten beiden antisymmetrischen Moden angeregt. Das Ausgangssignal wird von den Sammelelektroden 812 und 842 abgenommen, und das gemeinsame Ausgangssignal wird als Eingangssignal auf die spiegelsymmetrisch zur Achse 3 liegende Struktur 2 gegeben.

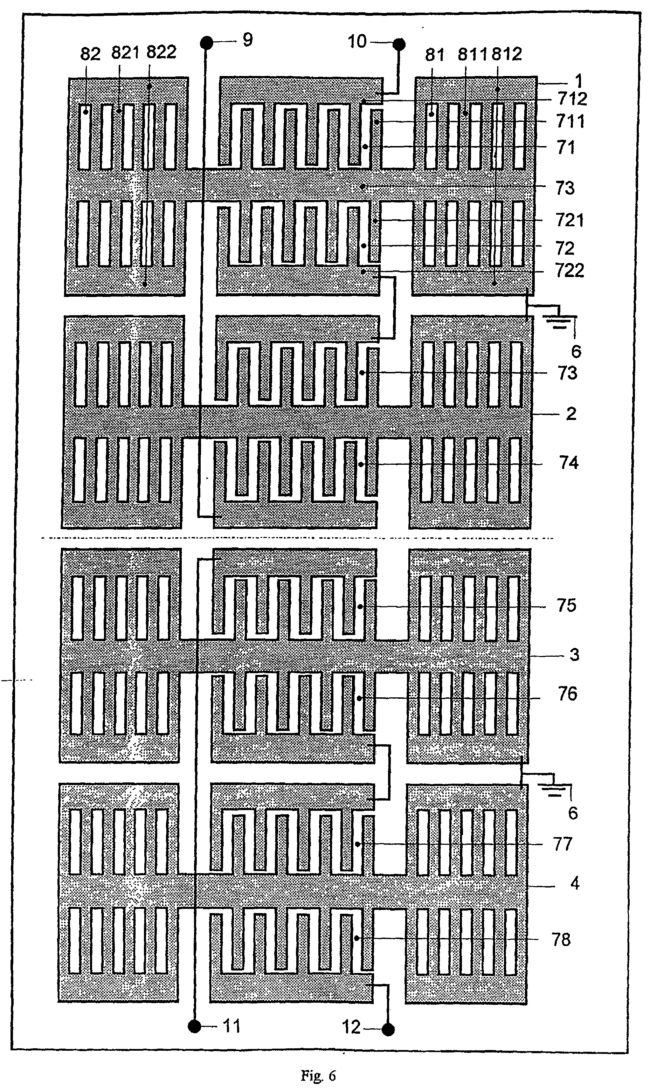

Ein fünftes Lösungsbeispiel ist in Fig. 6 dargestellt. Dieses Lösungsbeispiel basiert auf der bekannte Kaskadierung von zwei Oberflächenwellenresonatoranordnungen, die aus zwei interdigitalen Wandlern mit beiderseits dieser Wandler angeordneten Streifenreflektoren aufgebaut ist, wobei diese Wandler symmetrisch bzw. antisymmetrisch zu einer zu beiden Wandlern gehörenden gemeinsamen Sammelelektrode liegen. Mit dieser Struktur können Modenkombinationen wie erste symmetrische und erste antisymmetrische, oder erste und zweite symmetrische und erste und zweite antisymmetrische Mode verwendet werden.

Das Lösungsbeispiel besteht aus vier unabhängigen, identischen Oberflächenwellenresonatorstrukturen 1,2,3 und 4, deren Aufbau denen der bekannten Anordnung entspricht. Die Struktur 1 besteht aus zwei interdigitalen Wandlern 71,72, deren Wandlerfinger 711,721 alternierend an die jeweiligen Sammelelektroden 712, 73,722 angeschlossen sind, sowie Streifenreflektoren 81,82 mit Metallstreifen 811,821, die sowohl über Elektroden 812, 822 als auch über die bis zu den äußeren Begrenzungen der Streifenreflektoren verlängerte gemeinsame Sammelelektrode 73, elektrisch kurzgeschlossen sind. Die Wandlerfinger 711,721 und die Reflektorstreifen 811,821 sind zueinander parallel angeordnet. Die Sammelelektrode 73 ist über die elektrisch kurzgeschlossenen Streifenreflektoren mit der Masse 6 verbunden. Somit arbeiten beide Wandler 71 und 72 gegen Masse. Die vier identischen Teile sind wie folgt miteinander verschaltet. Die beiden Strukturen 1 und 2 und die beiden Strukturen 3 und 4 bilden je eine elektrische Einheit, sie sind zueinander spiegelsymmetrisch angeordnet. Die eine Phase des symmetrischen Eingangssignals 9 wird auf den Wandler 74 gegeben, die andere 10 auf den Wandler 71. An Wandler 78 und 75 werden die beiden Phasen des symmetrischen Ausgangssignals abgenommen. Folglich arbeitet jede der Anordnungen oberhalb bzw. unterhalb der Mittellinie 5 für eine Signalphase gegen Masse. Diese Art der Signalverarbeitung ist möglich, weil alle 4 Oberflächenwellenresonatoranordnungen auf dem gleichen piezoelektrischen Substrat angeordnet sind und somit unterschiedliche Signallaufzeiten vermieden werden.

## Patentansprüche

1. Akustisches Oberflächenwellenbauelement, bei dem zwei akustische Oberflächenwellenresonatoranordnungen über elektrisch leitende Verbindungen oder über Zweipole derart verschaltet sind, daß der Ausgang einer vorangehenden mit dem Eingang einer nachfolgenden Oberflächenwellenresonatoranordnungen verbunden ist, wobei jede der akustischen Oberflächenwellenresonatoranordnungen aus zwei auf einem gemeinsamen piezoelektrischen Substrat liegenden interdigitalen Wandlern mit beiderseits dieser Wandler angeordneten Streifenreflektoren aufgebaut ist und diese Wandler symmetrisch bzw. antisymmetrisch zu einer zu beiden Wandlern gehörenden gemeinsamen Sammelelektrode angeordnet sind, die sich bis an die äußeren Begrenzungen beider Streifenreflektoren, jedoch mindestens über die Länge der interdigitalen Wandler erstreckt,
**dadurch gekennzeichnet,**
**daß** die gemeinsame Sammelelektrode einer oder beider der zwei Oberflächenresonatoranordnungen galvanisch so geteilt ist, daß gleich viele oder annähernd gleich viele Wandlerfinger beider Wandler an die zwei durch die Teilung entstehenden Sammelelektroden angeschlossen sind, wobei die in den interdigitalen Wandlern verwendete Anschlußordnung, d. h. ein alternierender Anschluß der Finger an die beiden Sammelelektroden eines interdigitalen Wandlers, an der Stelle der Teilung der gemeinsamen Sammelelektrode umgekehrt wird, und daß je eine Phase des symmetrischen Eingangs- oder Ausgangssignales an je eine der beiden durch die Teilung der gemeinsamen Sammelelektrode entstehenden Elektroden angeschlossen ist.

2. Akustisches Oberflächenwellenbauelement, bei dem zwei akustische Oberflächenwellenresonatoranordnungen über elektrisch leitende Verbindungen oder über Zweipole derart verschaltet sind, daß der Ausgang einer vorangehenden mit dem Eingang einer nachfolgenden Oberflächenwellenresonatoranordnung verbunden ist, wobei jede dieser akustischen Oberflächenwellenresonatoranordnungen aus vier parallel zueinander auf einem gemeinsamen piezoelektrischen Substrat liegenden interdigitalen Wandlern und beiderseits dieser Wandler angeordneten Streifenreflektoren aufgebaut ist, deren innere interdigitale Wandler symmetrisch bzw. antisymmetrisch zu einer zu beiden Wandlern gehörenden gemeinsamen Sammelelektrode angeordnet sind, die sich mit Unterbrechungen zwischen interdigitalem Wandler und dem linken und rechten Streifenreflektor bis an die äußeren Begrenzungen beider Streifenreflektoren, jedoch mindestens über die Länge der interdigitalen Wandler erstreckt, und deren äußere interdigitale Wandler symmetrisch bzw. antisymmetrisch zu der gemeinsamen Sammelelektrode der inneren Wandler sind und die inneren Sammelelektroden der äußeren Wandler mit den äußeren Sammelelektroden der inneren Wandler gemeinsame Elektroden bilden, und diese gemeinsamen Elektroden sich mit möglichen Unterbrechungen zwischen den interdigitalen Wandlern und dem linken und rechten Streifenreflektor bis an die äußeren Begrenzungen beider Streifenreflektoren, jedoch mindestens über die Länge der interdigitalen Wandler erstrecken,
**dadurch gekennzeichnet,**
**daß** die gemeinsame Sammelelektrode der mittleren interdigitalen Wandler einer oder beider der zwei Oberflächenwellenresonatoranordnungen oder die äußeren Sammelelektroden der äußeren interdigitalen Wandler einer oder beider der zwei Oberflächenwellenresonatoranordnungen galvanisch so geteilt sind, daß gleich viele oder annähernd gleich viele Wandlerfinger der anliegenden Wandler an die durch die Teilung entstehenden Sammelelektroden angeschlossen sind, wobei in beiden Fällen die in den interdigitalen Wandlern verwendete Anschlußordnung, d. h. ein alternierender Anschluß der Finger an die beiden Sammelelektroden eines interdigitalen Wandlers, an der Stelle der Teilung der Sammelelektroden umgekehrt wird und dass einerseits bei Teilung der gemeinsamen Sammelelektrode der mittleren interdigitalen Wandler je eine Phase des symmetrischen Eingangs- oder Ausgangssignales an je eine der beiden durch die Teilung der gemeinsamen Sammelelektrode der mittleren Wandler entstandenen Elektroden angeschlossen ist oder dass andererseits bei Teilung der äußeren Sammelelektrode der äußeren interdigitalen Wandler je eine Phase des symmetrischen Eingangs- oder Ausgangssignales an die beiden durch die Teilung entstehenden Elektroden, bei denen die Anschlußordnung der Finger vertauscht wurde und die beiden durch die Teilung entstehenden Elektroden bei denen die Anschlußordnung der Finger erhalten bleibt, angeschlossen ist.

3. Akustisches Oberflächenwellenbauelement, bei dem akustische Oberflächenwellenresonatoranordnungen über elektrisch leitende Verbindungen oder über Zweipole derart verschaltet sind, daß der Ausgang einer vorangehenden mit dem Eingang einer nachfolgenden Oberflächenwellenresonatoranordnung verbunden ist,
wobei jede der akustischen Oberflächenwellenresonatoranordnungen aus zwei auf einem gemeinsamen piezoelektrischen Substrat liegenden interdigitalen Wandlern mit beiderseits dieser Wandler angeordneten Streifenreflektoren aufgebaut ist und diese Wandler symmetrisch bzw. antisymmetrisch zu einer zu beiden Wandlern gehörenden gemeinsamen Sammelelektrode angeordnet sind, die sich bis an die äußeren Begrenzungen beider Streifenreflektoren, jedoch mindestens über die Länge der interdigitalen Wandler erstreckt,
wobei weiterhingilt;
daß die gemeinsame Sammelelektrode der ersten und/oder letzten der verschalteten akustischen Oberflächenwellenanordnungen so geteilt wird, daß aus der betreffenden Sammelelektrode zwei galvanisch voneinander getrennte Elektroden entstehen, die sich mindestens über die gesamte Länge der Wandler erstrecken und daß je eine Phase des symmetrischen Eingangs- oder Ausgangssignales an je eine Sammelelektrode des nicht mit vorangehenden oder nachfolgenden Oberflächenwellenresonatoranordnungen verbundenen interdigitalen Wandlers angeschlossen ist, **dadurch gekennzeichnet daß** die durch Teilung entstandene Elektrode des mit vorangehenden oder nachfolgenden Oberflächenwellenresonatoranordnungen verbundenen interdigitalen Wandlers mit Massepotential verbunden ist.

4. Akustisches Oberflächenwellenbauelement nach Anspruch 3, **dadurch gekennzeichnet, daß** zwei der verschalteten akustischen Oberflächenwellenresonatoranordnungen auf einem gemeinsamen piezoelektrischen Substrat angeordnet und elektrisch parallel geschaltet sind und daß die Verschaltung derart erfolgt, daß die nicht auf Massepotential liegenden Sammelelektroden der Wandler, die eine auf Massepotential liegende Sammelelektrode besitzen, elektrisch verbunden sind und jeweils zwei der restlichen Wandler mit Eingangs- bzw. Ausgangspotential versehen werden, wobei entweder je eine Phase des symmetrischen Eingangs- oder Ausgangssignales an die beiden der auf Massepotential liegenden Sammelelektrode der jeweiligen Oberflächenwellenresonatoranordnung zugewandten und abgewandten Sammelelektroden angeschlossen ist oder je eine Phase des symmetrischen Eingangs- oder Ausgangssignales an die der auf Massepotential liegenden Sammelelektrode der jeweiligen Oberflächenwellenresonatoranordnung zugewandten Elektrode des einen interdigitalen Wandlers und die der auf Massepotential liegenden Sammelelektrode der jeweiligen Oberflächenwellenresonatoranordnung abgewandten Elektrode des anderen digitalen Wandlers angeschlossen ist und bei je einem der an das symmetrische Eingangs- oder Ausgangssignal angeschlossenen interdigitalen Wandler die Anschlußordnung der Finger vertauscht ist, d.h. die Finger an die jeweils gegenüberliegende Sammelelektrode der Wandler angeschlossen sind.

5. Akustisches Oberflächenwellenbauelement, bei dem zwei akustische Oberflächenwellenresonatoranordnungen über elektrisch leitende Verbindungen oder über Zweipole derart verschaltet sind, daß der Ausgang einer vorangehenden mit dem Eingang einer nachfolgenden Oberflächenwellenresonatoranordnung verbunden ist, wobei jede dieser akustischen Oberflächenwellenresonatoranordnungen aus vier parallel zueinander auf einem gemeinsamen piezoelektrischen Substrat liegenden interdigitalen Wandlern und beiderseits dieser Wandler angeordneten Streifenreflektoren aufgebaut ist, deren innere interdigitale Wandler symmetrisch bzw. antisymmetrisch zu einer zu beiden Wandlern gehörenden gemeinsamen Sammelelektrode angeordnet sind, die sich mit Unterbrechungen zwischen interdigitalem Wandler und dem linken und rechten Streifenreflektor bis an die äußeren Begrenzungen beider Streifenreflektoren, jedoch mindestens über die Länge der interdigitalen Wandler erstreckt, und deren äußere interdigitale Wandler symmetrisch bzw. antisymmetrisch zu der gemeinsamen Sammelelektrode der inneren Wandler angeordnet sind und die inneren Sammelelektroden der äußeren Wandler mit den äußeren Sammelelektroden der inneren Wandler gemeinsame Elektroden bilden, und diese gemeinsamen Elektroden sich mit möglichen Unterbrechungen zwischen den interdigitalen Wandlern und dem linken und rechten Streifenreflektor bis an die äußeren Begrenzungen beider Streifenreflektoren, jedoch mindestens über die Länge der interdigitalen Wandler erstrecken, wobei eine oder beide der zwei Oberflächenwellenresonatoranordnungen **dadurch gekennzeichnet sind,**
**daß** die gemeinsamen Sammelelektroden der inneren und äußeren Wandler der zwei Oberflächenwellenresonatoranordnungen so geteilt werden, daß jeweils zwei galvanisch voneinander getrennte Elektroden entstehen, die sich mindestens über die gesamte Länge der Wandler erstrecken und dass als erste Möglichkeit die inneren Sammelelektroden der äußeren interdigitalen Wandler auf Massepotential liegen und daß eine Phase des symmetrischen Eingangsoder Ausgangssignales an die beiden äußeren Sammelelektroden und die andere Phase des symmetrischen Eingangs- oder Ausgangssignales an die gemeinsame Sammelelektrode der inneren interdigitalen Wandler angeschlossen ist oder dass als zweite Möglichkeit die äußeren Sammelelektroden der inneren interdigitalen Wandler auf Massepotential liegen und daß je eine Phase des symmetrischen Eingangs- oder Ausgangssignales an die innere Sammelelektrode des einen äußeren interdigitalen Wandlers und die äußere Sammelelektrode des anderen äußeren interdigitalen Wandlers angeschlossen ist oder dass als dritte Möglichkeit die äußeren Sammelelektroden der inneren interdigitalen Wandler auf Massepotential liegen und daß je eine Phase des symmetrischen Eingangs- oder Ausgangssignales an die beiden inneren und beiden äußeren Sammelelektroden der äußeren interdigitalen Wandler angeschlossen ist und daß bei einem der äußeren interdigitalen Wandler die Anschlußordnung der Finger vertauscht ist, d. h. die Finger an die jeweils gegenüberliegende Sammelelektrode der Wandler angeschlossen sind oder dass als vierte Möglichkeit die gemeinsame Sammelelektrode der inneren interdigitalen Wandler und die gemeinsamen Sammelelektroden der inneren und äußeren interdigitalen Wandler so geteilt sind, daß zwei galvanisch voneinander getrennte Elektroden entstehen, die sich mindestens über die gesamte Länge der Wandler erstrecken und daß die inneren Sammelelektroden der äußeren interdigitalen Wandler auf Massepotential liegen und daß je eine Phase des symmetrischen Eingangs- oder Ausgangssignals an die äußere Sammelelektrode des einen inneren interdigitalen Wandlers und die innere Sammelelektrode des anderen inneren interdigitalen Wandlers angeschlossen ist, und daß die Anschlußordnung der Finger eines der inneren interdigitalen Wandler vertauscht ist, d. h. die Finger an die jeweils gegenüberliegende Sammelelektrode dieser Wandler angeschlossen sind.

6. Akustisches Oberflächenwellenbauelement, bei dem zwei akustische Oberflächenwellenresonatoranordnungen über elektrisch leitende Verbindungen oder über Zweipole derart verschaltet sind, daß der Ausgang einer vorangehenden mit dem Eingang einer nachfolgenden Oberflächenwellenresonatoranordnung verbunden ist, wobei jede dieser akustischen Oberflächenwellenresonatoranordnungen aus vier parallel zueinander auf einem gemeinsamen piezoelektrischen Substrat liegenden interdigitalen Wandlern und beiderseits dieser Wandler angeordneten Streifenreflektoren aufgebaut ist, deren innere interdigitale Wandler symmetrisch bzw. antisymmetrisch zu einer zu beiden Wandlern gehörenden gemeinsamen Sammelelektrode angeordnet sind, die sich mit Unterbrechungen zwischen interdigitalem Wandler und dem linken und rechten Streifenreflektor bis an die äußeren Begrenzungen beider Streifenreflektoren, jedoch mindestens über die Länge der interdigitalen Wandler erstreckt, und deren äußere interdigitale Wandler symmetrisch bzw. antisymmetrisch zu der gemeinsamen Sammelelektrode der inneren Wandler angeordnet sind und die inneren Sammelelektroden der äußeren Wandler mit den äußeren Sammelelektroden der inneren Wandler gemeinsame Elektroden bilden, und diese gemeinsamen Elektroden sich mit möglichen Unterbrechungen zwischen den interdigitalen Wandlern und dem linken und rechten Streifenreflektor bis an die äußeren Begrenzungen beider Streifenreflektoren, jedoch mindestens über die Länge der interdigitalen Wandler erstrecken, wobei eine oder beide der zwei Oberflächenwellenresonatoranordnungen **dadurch gekennzeichnet sind,**
**daß** die beiden Phasen des symmetrischen Eingangs- oder Ausgangssignales an je eine äußere Sammelelektrode der äußeren interdigitalen Wandler angeschlossen ist und **daß** die Anschlußordnung der Finger eines der äußeren interdigitalen Wandler vertauscht ist, d. h. die Finger an die jeweils gegenüberliegende Sammelelektrode dieser Wandler angeschlossen sind.

## Claims

1. Acoustical surface wave structural element where two acoustical surface wave resonator arrangements are interconnected by way of electrically conducting connections or by way of two-terminal networks in such a way that the output of a preceding surface wave resonator arrangement is connected with the input of a subsequent surface wave resonator arrangement, where each of the acoustical surface wave resonator arrangements is built up from two interdigital transformers lying on a common piezoelectric substrate with strip reflectors arranged on both sides of these transformers, and these transformers are arranged symmetrically and/or antisymmetrically to a common busbar electrode belonging to the two transformers, where this busbar electrode reaches to the outer limits of both strip reflectors, however at least over the length of the interdigital transformers,
wherein
the common busbar electrode of one or of both of the two surface wave resonator arrangements are galvanically divided in such a way that as many or approximately as many transformer fingers of both transformers are connected to the two busbar electrodes resulting from the division, where the connection arrangement as applied in the interdigital transformers, meaning an alternating connection of the fingers to the two busbar electrodes of an interdigital transformer, is reversed at the location of the division of the common busbar electrode and that a phase, in each case, of the symmetrical input or output signals is connected to each one of the two electrodes resulting from the division of the common busbar electrode.

2. Acoustical surface wave structural element where two acoustical surface wave resonator arrangements are interconnected by way of electrically conducting connections or by way of two-terminal networks in such a way that the output of a preceding surface wave resonator arrangement is connected with the input of a subsequent surface wave resonator arrangement, where each of these acoustical surface wave resonator arrangements is built up from four interdigital transformers lying parallel to each other on a common piezoelectric substrate, and strip reflectors arranged on both sides of these transformers, whose inner interdigital transformers are arranged symmetrically and/or antisymmetrically to a common busbar electrode belonging to both transformers, where this busbar electrode, with interruptions between interdigital transformer and the left and right strip reflector, reaches to the outer limits of both strip reflectors, however at least over the length of the interdigital transformers, and whose outer interdigital transformers are symmetric and/or antisymmetric to the common busbar electrode of the inner transformers, and the inner busbar electrodes of the outer transformers with the outer busbar electrodes of the inner transformers form common electrodes, and these common electrodes, with possible interruptions between the interdigital transformers and the left and right strip reflector, reach to the outer limits of both strip reflectors, however at least over the length of the interdigital transformers,
wherein
the common busbar electrode of the middle interdigital transformers of one or of both of the two surface wave resonator arrangements or the outer busbar electrodes of the outer interdigital transformers of one or both of the two surface wave resonator arrangements are galvanically divided in such a way that as many or approximately as many transformer fingers of the adjacent transformers are connected to the busbar electrodes resulting from the division, where in both cases the connection arrangement as applied in the interdigital transformers, meaning an alternating connection of the fingers to the two busbar electrodes of an interdigital transformer, is reversed at the location of the division of the common busbar electrode and that, on the one hand, upon division of the common busbar electrode of the middle interdigital transformers, a phase each of the symmetrical input signal or output signal is connected to each of one of the two electrodes resulting from the division of the common busbar electrode of the middle transformers, and that on the other hand, upon division of the outer busbar electrode of the outer interdigital transformers, a phase each of the symmetrical input or output signal is connected to the two electrodes resulting from the division, where the connection arrangement of the fingers was interchanged, and the two electrodes resulting from the division where the connection arrangement of the fingers remains upheld.

3. Acoustical surface wave structural element where acoustical surface wave resonator arrangements are interconnected by way of electrically conducting connections or by way of two-terminal networks in such a way that the output of a preceding surface wave resonator arrangement is connected with the input of a subsequent surface wave resonator arrangement, where each of these acoustical surface wave resonator arrangements is built up from two interdigital transformers lying on a common piezoelectric substrate, and strip reflectors arranged on both sides of these transformers, and these transformers are arranged symmetrically and/or antisymmetrically to a common busbar electrode belonging to the two transformers, where this busbar electrode reaches to the outer limits of both strip reflectors, however at least over the length of the interdigital transformers,
where it is furthermore applicable that
the common busbar electrode of the first and/or the last of the interconnected acoustical surface shaft arrangements is divided in such a way that, from the busbar electrode concerned, two electrodes galvanically separated from each other are created which reach at least over the entire length of the transformers and that a phase each of the symmetrical input or output signal is connected to each of one busbar electrode of the interdigital transformer not joined with preceding or subsequent surface wave resonator arrangements,
wherein
the electrode, created from the division, of the interdigital transformer joined with the preceding or subsequent surface wave resonator arrangements is joined with frame potential.

4. Acoustical surface wave structural element according to Claim 3, wherein two of the interconnected acoustical surface wave resonator arrangements are arranged on a common piezoelectric substrate and connected electrically in parallel, and that the interconnection is effected in such a way that the busbar electrodes of the transformers not lying on frame potential which have a busbar electrode lying on frame potential are electrically joined and two each of the remaining transformers are provided with input and/or output potential, where either a phase each of the symmetrical input or output signal is connected to the two busbar electrodes, lying on frame potential, of the busbar electrodes facing towards and facing away from the respective surface wave resonator arrangement, or a phase each of the symmetrical input or output signal is connected to the busbar electrode, lying on frame potential, of the electrode of the one interdigital transformer facing the respective surface wave resonator arrangement and the busbar electrode, lying on frame potential, of the electrode of the other digital transformer facing away from the respective surface wave resonator arrangement, and at each of the interdigital transformers connected to the symmetrical input or output signal the connection arrangement of the fingers are interchanged, meaning, the fingers are connected to the opposite busbar electrode of the transformers in each case.

5. Acoustical surface wave structural element where two acoustical surface wave resonator arrangements are interconnected by way of electrically conducting connections or by way of two-terminal networks in such a way that the output of a preceding surface wave resonator arrangement is connected with the input of a subsequent surface wave resonator arrangement, where each of these acoustical surface wave resonator arrangements is built up from four interdigital transformers lying parallel to each other on a common piezoelectric substrate, and strip reflectors arranged on both sides of these transformers, whose inner interdigital transformers are arranged symmetrically and/or antisymmetrically to a common busbar electrode belonging to both transformers, where this busbar electrode, with interruptions between interdigital transformer and the left and right strip reflector, reaches to the outer limits of both strip reflectors, however at least over the length of the interdigital transformers, and whose outer interdigital transformers are arranged symmetrically and/or antisymmetrically to the common busbar electrode of the inner transformers and the inner busbar electrodes of the outer transformers form common electrodes with the outer busbar electrodes of the inner transformers, and these common electrodes, with possible interruptions between the interdigital transformers and the left and right strip reflector, reach to the outer limits of both strip reflectors, however at least over the length of the interdigital transformers,
where one or both surface wave resonator arrangements are **characterised in that**
the common busbar electrodes of the inner and outer transformers of the two surface wave resonator arrangements are divided in such a way that electrodes galvanically separated from each other are created which reach at least over the entire length of the transformers and that, as a first possibility, the inner busbar electrodes of the outer interdigital transformers are lying on frame potential and that one phase of the symmetrical input or output signal is connected to the two outer busbar electrodes, and the other phase of the symmetrical input or output signal is connected to the common busbar electrode of the inner digital transformer and that, or as a second possibility, the outer busbar electrodes of the inner interdigital transformers are lying on frame potential and that a phase each of the symmetrical input or output signal is connected to the inner busbar electrode of an outer interdigital transformer and the outer busbar electrode of the other outer interdigital transformer, or as a third possibility, that the outer busbar electrodes of the inner interdigital transformers are lying on frame potential and that a phase each of the symmetrical input or output signal is connected to both inner and to both outer busbar electrodes of the outer interdigital transformers, and that with one of the outer interdigital transformers the connection arrangement of the fingers is interchanged, meaning, the fingers are connected to the opposite busbar electrode of the transformer in each case, or as a fourth possibility, that the common busbar electrode of the inner interdigital transformers and the common busbar electrodes of the inner and outer interdigital transformers are divided in such a way that two electrodes galvanically separated from each other are created, which reach at least over the entire length of the transformers and that the inner busbar electrodes of the outer interdigital transformers are lying on frame potential, and that a phase each of the symmetrical input or output signal is connected to the outer busbar electrode of the one inner interdigital transformer and the inner busbar electrode of the other inner interdigital transformer, and that the connection arrangement of the fingers of one of the inner interdigital transformers is interchanged, meaning, the fingers are connected to the opposite busbar electrode of these transformers in each case.

6. Acoustical surface wave structural element where two acoustical surface wave resonator arrangements are interconnected by way of electrically conducting connections or by way of two-terminal networks in such a way that the output of a preceding surface wave resonator arrangement is connected with the input of a subsequent surface wave resonator arrangement, where each of these acoustical surface wave resonator arrangements is built up from four interdigital transformers lying parallel to each other on a common piezoelectric substrate, and strip reflectors arranged on both sides of these transformers, whose inner interdigital transformers are arranged symmetrically and/or antisymmetrically to a common busbar electrode belonging to both transformers, where this busbar electrode, with interruptions between interdigital transformer and the left and right strip reflector, reaches to the outer limits of both strip reflectors, however at least over the length of the interdigital transformers, and whose outer interdigital transformers are arranged symmetric and/or antisymmetric to the common busbar electrode of the inner transformers, and the inner busbar electrodes of the outer transformers form common electrodes with the outer busbar electrodes, and these common electrodes, with possible interruptions between the interdigital transformers and the left and right strip reflector, reach to the outer limits of both strip reflectors, however at least over the length of the interdigital transformers, where one or both of the two surface wave resonator arrangements are **characterised in that**
the two phases of the symmetrical input or output signal are connected to an outer busbar electrode, in each case, of the outer interdigital transformers, and that the connection arrangement of the fingers of the outer interdigital transformer is interchanged, meaning, the fingers are connected in each case to the opposite located busbar electrode of these transformers.

## Revendications

1. Composant à onde acoustique de surface dans lequel deux dispositifs de résonateur à onde acoustique de surface sont connectés au moyen de liaisons électro-conductrices ou au moyen de dipôles de manière à ce que la sortie d'un dispositif de résonateur à onde acoustique de surface situé en amont soit lié à l'entrée d'un dispositif de résonateur à onde acoustique de surface situé en aval, chacun des dispositifs de résonateur à onde acoustique de surface étant composés de deux transducteurs interdigités situés sur un substrat piézoélectrique commun avec des réflecteurs à bande disposés des deux côtés des transducteurs; lesdits transducteurs étant disposés de manière symétrique ou antisymétrique par rapport à une électrode collectrice commune appartenant au deux transducteurs; laquelle électrode s'étend jusqu'à la limite extérieure des deux réflecteurs à bande au moins sur la longueur des transducteurs interdigités,
**caractérisé en ce que** l'électrode collectrice commune d'un ou deux dispositifs de résonateur à onde acoustique de surface est séparé de manière galvanique et de manière à ce que le même ou à peu près le même nombre de doigts de transducteurs des deux transducteurs est connecté aux deux électrodes collectrices créées par la séparation, la disposition de connexion utilisée dans les transducteurs interdigités, c'est à dire que la connexion alternée des doigts sur les deux électrodes collectrices d'une transducteur interdigité est inversée à l'endroit de la séparation de l'électrode collectrice commune, et
**caractérisé en ce que** chaque fois, une phase du signal symétrique d'entrée ou de sortie est connectée sur chacune des deux électrodes créées par la. séparation de l'électrode collectrice commune.

2. Composant à onde acoustique de surface dans lequel deux dispositifs de résonateur à onde acoustique de surface sont connectés au moyen de liaisons électro-conductrices ou au moyen de dipôles de manière à ce que la sortie d'un dispositif de résonateur à onde acoustique de surface situé en amont soit lié à l'entrée d'une dispositif de résonateur à onde acoustique de surface situé en aval; chacun des dispositifs de résonateur à onde acoustique de surfacé étant composés de deux transducteurs interdigités situés sur un substrat piézoélectrique commun avec des réflecteurs à bande disposés des deux côtés des transducteurs et lesdits transducteurs étant disposés de manière symétrique ou antisymétrique par rapport à une électrode collectrice commune appartenant au deux transducteurs; laquelle électrode s'étend jusqu'à la limite extérieure des deux réflecteurs à bande au moins sur la longueur des transducteurs interdigités; les transducteurs extérieurs interdigités des dispositifs de résonateur à onde acoustique de surface sont symétriques ou antisymétriques par rapport à l'électrode collectrice commune des transducteurs intérieurs et les électrodes collectrices intérieures des transducteurs extérieurs forment des électrodes communes avec les électrodes intérieures, et
**caractérisé en ce que** ces électrodes communes s'étendent, avec des interruptions possibles entre les transducteurs interdigités et le réflecteur à bande gauche et droit jusqu'aux limites extérieures des deux réflecteurs à bande au moins sur la longueur des transducteurs interdigités,
**caractérisé en ce que** l'électrode collectrice commune des transducteurs interdigités médians d'un ou deux dispositifs de résonateur à onde acoustique de surface ou les électrodes collectrices extérieures des transducteurs interdigités extérieurs d'un ou deux dispositifs de résonateur à onde acoustique de surface est séparée de manière galvanique et de manière à ce que le même ou à peu près le même nombre de doigts de transducteurs des deux transducteurs est connecté aux deux électrodes collectrices créées par la séparation; la disposition de connexion utilisée dans les deux cas dans les transducteurs interdigités, c'est à dire une connexion alternant des doigts sur les deux électrodes collectrices d'un transducteur interdigité étant inversée à l'endroit de la séparation de l'électrode collectrice commune, et
**caractérisé en ce que**, d'une part chaque fois, au cours de la séparation des électrodes collectrices communes des transducteurs interdigités médians, une phase du signal symétrique d'entrée ou de sortie est connectée sur chacune des deux électrodes crées par la séparation de 1 'électrode collectrice commune des transducteurs médians et
**caractérisé en ce que**, d'autre part, chaque fois, au cours de la séparation des électrodes collectrices extérieures des transducteurs interdigités extérieurs, une phase du signal symétrique d'entrée ou de sortie est connectée sur les deux électrodes créées par la séparation, pour lesquelles électrodes l'ordre de connexion des doigts était inversé et pour lesquelles paires d'électrodes créées par la séparation l'ordre de connexion des doigts est maintenu.

3. Composant à onde acoustique de surface dans lequel des dispositif de résonateur à onde acoustique de surface sont connectés au moyen de liaisons électro-conductrices ou au moyen de dipôles de manière à ce que la sortie d'un dispositif de résonateur à onde acoustique de surface situé en amont soit liée à l'entrée d'un dispositif de résonateur à onde acoustique de surface situé en aval; chacun des dispositifs de résonateur à onde acoustique de surface étant composés de deux transducteurs interdigités situés sur un substrat piézoélectrique commun avec des réflecteurs à bande disposés des deux côtés des transducteurs; lesdits transducteurs étant disposés de manière symétrique ou antisymétrique par rapport à une électrode collectrice commune appartenant au deux transducteurs; laquelle électrode s'étend jusqu'à la limite extérieure des deux réflecteurs à bande, par contre, au moins sur la longueur des transducteurs interdigités, où il est, en outre, exigé, que l'électrode collectrice commune du premier et / ou dernier dispositif de résonateur à onde acoustique de surface connecté soit séparé de manière à ce que deux électrodes séparées de manière galvanique l'une de l'autre soient créées en s'étendant au moins sur toute la longueur des transducteurs et que, chaque fois, une phase du signal symétrique d'entrée ou de sortie soit connectée à une électrode collectrice du transducteur interdigité n'étant pas relié aux dispositifs de résonateur à onde de surface situés en amont ou en aval, **caractérisé en ce que** l'électrode, créée lors de la séparation du transducteur interdigité relié aux dispositifs de résonateur à onde de surface situées en amont ou en aval, est connectée au potentiel de masse.

4. Composant à onde acoustique de surface selon la revendication 3, **caractérisé en ce que** deux des dispositifs connectés de résonateur à onde acoustique de surface sont disposés sur un substrat piézoélectrique commun et sont connectés électriquement en parallèle et **caractérisé en ce que** la connexion est effectuée de manière à ce que les électrodes collectrices qui ne sont pas situées sur un potentiel de masse - les transducteurs possédant une électrode collectrice située sur un potentiel de masse-sont électriquement liées et **en ce que** chaque fois, deux des transducteurs restant sont pourvus d'un potentiel d'entrée et de sortie, dans lequel cas une phase du signal symétrique d'entrée ou de sortie est connectée aux deux électrodes de l'électrode collectrice située sur le potentiel de masse et où les électrodes collectrices sont détournées de ou tournées vers le dispositif correspondant de résonateur à onde acoustique de surface; une phase du signal symétrique d'entrée ou de sortie étant à chaque fois connectée à l'électrode de l'un des transducteurs interdigité; laquelle électrode est située sur le potentiel de masse et est détournée du dispositif correspondant de résonateur à onde acoustique de surface et, chaque fois, pour un des transducteurs interdigités, connecté au signal symétrique d'entrée ou de sortie, l'ordre de connexion des doigts est inversé, c'est à dire que les doigts sont connectés à l'électrode collectrice du transducteur se faisant face à chaque fois.

5. Composant à onde acoustique de surface dans lequel deux dispositifs de résonateur à onde acoustique de surface sont connectés au moyen de liaisons électro-conductrices ou au moyen de dipôles de manière à ce que la sortie d'un dispositif de résonance à onde acoustique de surface situé en amont soit lié à l'entrée d'un dispositif de résonateur à onde acoustique de surface situé en aval, chacun de ces dispositifs de résonateur à onde acoustique de surface étant composés de quatre transducteurs interdigités situés de manière parallèle l'un par rapport à l'autre sur un substrat piézoélectrique commun avec des réflecteurs à bande, disposés des deux côtés des transducteurs; les transducteurs interdigités intérieurs des dispositifs de résonateurs à onde acoustique de surface étant disposés de manière symétrique ou antisymétrique par rapport à une électrode collectrice commune appartenant aux deux transducteurs; laquelle électrode collectrice commune s'étend, avec des interruptions, jusqu'à la limite extérieures des deux réflecteurs à bande entre le transducteur interdigité et le réflecteur à bande gauche et droit et les transducteurs interdigités extérieurs des dispositifs de résonateurs à onde acoustique de surface étant disposés de manière symétrique ou antisymétrique par rapport à l'électrode collectrice commune; les électrodes collectrices intérieures des transducteurs extérieurs formant des électrodes communes avec les électrodes collectrices extérieures des transducteurs intérieurs; lesdites électrodes communes s'étendant au moins sur la longueur des transducteurs interdigités avec des interruptions possibles entre les transducteurs interdigités et le réflecteur à bande gauche et droit jusqu'à la limite extérieure des deux réflecteurs à bande, une ou les deux des deux dispositifs de résonateur à onde acoustique de surface **étant caractérisé par le fait: que** les électrodes collectrices communes des transducteurs intérieurs et extérieurs des deux dispositifs de résonateur à onde acoustique de surface sont séparées de manière à ce que, à chaque fois, deux électrodes séparées de manière galvanique l'une de l'autre soient créées, lesquelles électrodes s'étendent au moins sur toute la longueur des transducteurs et en ce que, comme première possibilité, les électrodes collectrices intérieures des transducteurs interdigités extérieurs sont appliquées sur le potentiel de masse et en ce qu'une phase du signal symétrique d'entrée ou de sortie est connectée aux deux électrodes collectrices communes extérieurs et l'autre phase du signal symétrique d'entrée ou de sortie est connectée à l'électrode collectrice commune des transducteurs interdigités intérieurs et en ce que, comme deuxième possibilité, les électrodes collectrices extérieures des transducteurs interdigités intérieurs sont appliquées sur le potentiel de masse et en ce que, à chaque fois, une phase du signal symétrique d'entrée ou de sortie est connectée à l'électrode collectrice intérieure de l'un des transducteurs interdigités extérieurs et à l'électrode collectrice extérieure de l'autre transducteur interdigité extérieur, et en ce que, comme troisième possibilité, les électrodes collectrices extérieures des transducteurs interdigités intérieurs s'appliquent sur le potentiel de masse et en ce que, à chaque fois, une phase du signal symétrique d'entrée ou de sortie est connectée aux deux électrodes collectrices intérieures et aux deux électrodes collectrices extérieures des transducteurs interdigités extérieurs et en ce que pour un des transducteurs interdigités extérieurs l'ordre de connexion des doigts est inversé, c'est à dire que les doigts sont connectés, à chaque fois, à l'électrode collectrice faisant face au doigt du transducteur, et en ce que, comme quatrième possibilité, l'électrode collectrice commune du transducteur interdigité intérieur et les électrodes collectrice communes des transducteurs interdigités intérieurs et extérieurs sont séparées de manière à créer deux électrodes séparées de manière galvanique qui s'étendent au moins sur toute la longueur des transducteurs et en ce que les électrodes collectrices intérieures des transducteurs interdigités extérieurs s'appliquent sur le potentiel de masse et en ce que, à chaque fois, une phase du signal symétrique d'entrée ou de sortie est connectée à l'électrode collectrice extérieure de l'un des transducteurs interdigités intérieurs et à l'électrode collectrice intérieure de l'autre transducteur interdigité intérieur et en ce que, pour un des transducteurs interdigités intérieurs, l'ordre de connexion des doigts est inversé, c'est à dire que les doigts sont connectés à chaque fois à l'électrode collectrice faisant face à ces transducteurs.

6. Composant à onde acoustique de surface dans lequel deux dispositifs de résonateur à onde acoustique de surface sont connectés au moyen de liaisons électro-conductrices ou au moyen de dipôles de manière à ce que la sortie d'un dispositif de résonance à onde acoustique de surface situé en amont soit liée à l'entrée d'un dispositif de résonateur à onde acoustique de surface situé en aval, chacun de ces dispositifs de résonateur à onde acoustique de surface étant composés de quatre transducteurs interdigités situés de manière parallèle l'un par rapport à l'autre sur un substrat piézoélectrique commun avec des réflecteurs à bande disposés des deux côtés des transducteurs; les transducteurs interdigités intérieurs des dispositifs de résonateurs à onde acoustique de surface étant disposés de manière symétrique ou antisymétrique par rapport à une électrode collectrice commune appartenant aux deux transducteurs; laquelle électrode collectrice commune s'étend avec des interruptions jusqu'à la limite extérieure des deux réflecteurs à bande entre le transducteur interdigité et le réflecteur à bande gauche et droit et les transducteurs interdigités extérieurs des dispositifs de résonateurs à onde acoustique de surface étant disposés de manière symétrique ou antisymétrique par rapport à l'électrode collectrice commune et les électrodes collectrices intérieures des transducteurs extérieurs formant des électrodes communes avec les électrodes collectrices extérieures des transducteurs intérieurs et ces électrodes communes s'étendant au moins sur la longueur des transducteurs interdigités avec des interruptions possibles entre les transducteurs interdigités et le réflecteur à bande gauche et droit jusqu'à la limite extérieure des deux réflecteurs à bande, une ou les deux des deux dispositifs de résonateur à onde acoustique de surface étant **caractérisé par le fait que** les deux phases du signal symétrique d'entrée ou de sortie sont connectées, à chaque fois, à l'électrode collectrice extérieure des transducteurs interdigités extérieurs et **par le fait que** l'ordre de connexion des doigts de l'un des transducteurs interdigités extérieurs est inversé, c'est à dire que les doigts sont connectés à l'électrode collectrice faisant face au transducteur correspondant.
